# EUROPEAN PATENT APPLICATION

(11) **EP 0 534 729 A2**
(43) Date of publication of application: **31.03.1993**
(21) Application number: 92308651.6
(22) Date of filing: 23.09.1992
(51) Int. Cl.: C23C 16/26, C23C 16/02, C30B 25/02, C30B 29/04

(54) **Method for obtaining thick, adherent diamond coatings**

(30) Priority: 27.09.1991 US 766932
(71) Applicant: GENERAL ELECTRIC COMPANY, Schenectady, NY 12345 (US)
(72) Inventor: Kehl, Randall J., Scotia, New York 12302 (US)
(74) Representative: Pratt, Richard Wilson

(57) **Abstract**

A method for coating a substrate with a layer of chemical vapor deposition (CVD) diamond comprises attaching a screen to the area of the substrate to be coated and coating said screened area with a layer of CVD diamond. Preferably, the screen is attached only at its edges by spot welding or arc welding the screen to the area of the surface where the diamond coating is desired. The screen serves two functions : it creates a more favorable surface for diamond deposition; and it provides a semi-flexible surface that aids to relax stresses that occur in the diamond film both during growth and during cool down to room temperature. The screen may be made from carbide-forming materials, such as Mo or W, to create a surface that is more favorable for diamond growth. Upon cooling, the fine screen distorts to relieve the compressive stresses that occur in the film due to diamond's low coefficient of thermal expansion. Although the diamond may not be in direct physical contact with the underlying substrate, a good physical bond is provided by the welding process, thereby allowing the diamond film to remain intact and serve as a protective coating.

## Description

### Background of the Invention

The present invention relates to coating substrates with a layer of chemical vapor deposition diamond more particularly to their fabrication using an interfacial screen.

Its hardness and thermal properties are but two of the characteristics that make diamond useful in a variety of industrial components. Initially, natural diamond was used in a variety of abrasive applications. With the ability to synthesize diamond by high pressure/high temperature (HP/HT) techniques a catalyst/sintering aid under conditions where diamond is the thermally stable carbon phase, a variety of additional products found favor in the marketplace. Polycrystalline diamond compacts, often supported on a tungsten carbide supports in cylindrical or annular form, extended the product line for diamond additionally. However, the requirement of high pressure and high temperature has been a limitation in product configuration, for example.

Recently, industrial effort directed toward the growth of diamond at low pressures, where it is metastable, has increased dramatically. Although the ability to produce diamond by low-pressure synthesis techniques has been known for decades, drawbacks including extremely low growth rates prevented wide commercial acceptance. Recent developments have led to higher growth rates, thus spurring recent industrial interest in the field. Additionally, the discovery of an entirely new class of solids, known as "diamond like" carbons and hydrocarbons, is an outgrowth of such recent work.

Low pressure growth of diamond has been dubbed "chemical vapor deposition" or "CVD" in the field. Two predominant CVD techniques have found favor in the literature. One of these techniques involves the use of a dilute mixture of hydrocarbon gas (typically methane) and hydrogen wherein the hydrocarbon content usually is varied from about 0.1% to 2.5% of the total volumetric flow. The gas introduced via a quartz tube located just above a hot tungsten filament which is electrically heated to a temperature ranging from between about 1,750° to 2,400°C. The gas mixture disassociates at the filament surface and diamonds are condensed onto a heated substrate placed just below the hot tungsten filament. The substrate is held in a resistance heated boat (often molybdenum) and heated to a temperature in the region of about 500° to 1,100°C.

The second techniques involves the imposition of a plasma discharge to the foregoing filament process. The discharge serves to increase the nucleation density, growth rate, and it is believed to enhance formation of diamond films as opposed to discrete diamond particles. Of the plasma systems that have been utilized in this area, there are three basic systems. One is a microwave plasma system, the second is an RF (inductively or capacitively coupled) plasma system, and the third is a d.c. plasma system. The Rf and microwave plasma systems utilize relatively complex and expensive equipment which usually requires complex tuning or matching networks to electrically couple electrical energy to the generated plasma. Additionally, the diamond growth rate offered by these two systems can be quite modest.

A problem that is typical to all CVD diamond processes is that the diamond does not adhere well to the substrate, especially after the coated substrate is cooled down to room temperature, due to the thermal mismatch of diamond and the metal substrate. There are two requirements that are needed to overcome poor adhesion. First, a favorable substrate surface is required for the diamond to bond to it. Some substrate materials are better than others. In general, metals that form carbides (*e.g*., molybdenum, tungsten, *etc*.) have been found to give the best adhesion with diamond. Thin diamond films (*e.g.* less than about 50,1 micron being 1 micrometer) adhere fairly well after cooling; however, when growing thick films (*e.g.* greater than 50 microns on up to about 2,000 microns or more), very little success has been made in keeping the diamond intact on the surface after cool down. Additionally, metals such as iron or cobalt promote graphitic formation and, usually, a soft graphitic interface is deposited prior to diamond growth, which leads to very adhesion between the diamond and the substrates containing these metals.

A second problem that needs to be overcome is the difference in coefficients of thermal expansion (CTE) between the diamond coating and the substrate material. Diamond has a lower CTE compared to typical substrate materials. For this problem, again, molybdenum and tungsten are most favorable with relatively low coefficients of thermal expansion (4.5-5 x 10⁻⁶cm/cm-°C), as opposed to iron or cobalt with CTE values of 12 x 10⁻⁶ cm/cm-°C. Thus, the use of CVD diamond as a protective coating against abrasion, corrosion, and erosion in many applications is limited.

### Broad Statement of the Invention

Broadly, the present invention is addressed to a method for coating a substrate with a layer of chemical vapor deposition (CVD) diamond. The inventive method comprises attaching a screen to the area of the substrate to be coated and coating said screened area with a layer of CVD diamond. Preferably, the screen is attached only at its edges by spot welding or arc welding the screen to the area of the surface where the diamond coating is desired. The screen serves two functions: it creates a more favorable for diamond deposition; and it provides a semi-flexible surface that aids to relax stresses that occur in the diamond film both during growth and during cool down to room temperature. The screen may be made from carbide-forming materials, such as Mo or W, to create a surface that is more favorable for diamond growth. Upon cooling, the fine screen distors to relieve the compressive stresses that occur in the film due to diamond's low coefficient of thermal expansion. Although the diamond may not be in direct physical contact with the underflying substrate, a good physical bond is provided by the welding process, thereby allowing the diamond film to remain intact and serve as a protective coating. Accordingly, the resulting screened substrate with a layer of CVD diamond overlaying the screen comprises another aspect of the present invention.

### Detailed Description of the Invention

The substrate, an area of which is desired to be coated with diamond, necessarily must be stable at the elevated CVD diamond-forming temperatures required by CVD processing techniques. Accordingly, appropriate substrates include, for example, metals (*e.g.* tungsten, molybdenum, silicon, and platinum), alloys, ceramics (*e.g*. silicon carbide, boron nitride, and aluminum nitride), glasses, and carbon. Because of the interposition of the screen between the substrate and the layer of CVD diamond, however, a variety of additional substrates that heretofore were not appropriate for coating with CVD diamond additionally may be used in accordance with the precepts of the present invention. As noted above, such substrates include those containing iron, cobalt, nickel, combinations and alloys thereof, and like graphite-promoting metals.

With respect to the screen, it will be appreciated that the coefficient of thermal expansion of the screen preferably should not be drastically higher than that of the diamond in order to minimize the risk of fracturing the diamond layer deposited during the CVD processing. Because the screen is able to contract and be distored during the cool down following deposition of the diamond layer, the CVD diamond layer should remain intact. Further, the attachment of the screen to the substrate ensures the placement of the diamond layer in close proximity to the surface of the area being coated for providing the desired protection realized using CVD diamond layers. Appropriate screen materials, preferably, then, include tungsten, molybdenum, tantalum, silicon, and platinum, though other materials may be used as is necessary, desirable, or convenient. The screen may be attached to the substrate by a variety of methods including, for example, brazing, spot welding, soldering; with clips, screws, or the like; and like methods that provide a good bond between the substrate and the screen, as this bond is the one that holds the diamond film to the substrate.

It is desirable to have a fine screen since the mechanism of forming diamond film relies on diamonds growing on individual wires and eventually growing together to form a continuous film. A finer screen allows a diamond continuum to be formed in less time also.

With respect to conventional CVD processes useful in the present invention, hyfrocarbon/hydrogen gaseous mixtures are fed into a CVD reactor as an initial step. Hydrocarbon sources can include the methane series gases, *e.g.* methane, ethane, propane; unsaturated hydrocarbons, *e.g.* ethylene, acetylene, cyclohexene, and benzene; and the like. Methane, however, is preferred. The molar ratio of hydrocarbon to hydrogen broadly ranges from about 1:10 to about 1:1,000 with about 1:100 being preferred. This gaseous mixture optionally may be diluted with an inert gas, *e.g.* argon. The gaseous mixture is at least partially decomposed thermally by one of several techniques known in the art. One of these techniques involves the use of a hot filament which normally is formed of tungsten, molybdenum, tantalum, or alloys thereof. U.S. Pat. No. 4,707,384 illustrates this process.

The gaseous mixture partial decomposition also can be conducted with the assistance of d.c. discharge or radio frequency electromagnetic radiation to generate a plasma, such as proposed in U.S. Pats. Nos. 4,749,587, 4,767,608, and 4,830,702; and U.S. Pat. No. 4,434,188 with respect to use of microwaves. The substrate may be bombarded with electrons during the CVD decomposition process in accordance with U.S. Pat. No. 4,740,263.

Regardless of the particular method used in generating the partially decomposed gaseous mixture, the substrate is maintained at an elevated CVD diamond-forming temperature which typically ranges from about 500° to 1,100° C and preferably in the range of about 850° to 950° C where diamond growth is at its highest rate in order to minimize grain size. Pressures in the range of from about 0.01 to 1000 Torr, advantageously about 100-800 Torr, are taught in the art, with reduced pressure being preferred. Details on CVD processes additionally can be reviewed by reference to Angus, *et al.,* "Low-Pressure, Metastable Growth of Diamond and 'Diamondlike' Phases", *Science,* vol. 241, pages 913-921 (August 19, 1988); and Bachmann, et al., "Diamond Thin Films", *Chemical and Engineering New,* pages 24-39 (May 15, 1989). The disclosures of all citations herein are expressly incorporated herein by reference.

The following example shows how the present invention has been practiced, but should not be construed as limiting. In this application, all gaseous percentages are molar and all units are in the metric system, unless otherwise expressly indicated. Also, all citations referred to herein are expressly incorporated herein by reference.

### EXAMPLE

The inventive method was used to obtain a diamond coating on a swirler venturi. The swirler venturi can best be described as a cone with inlet and exit diameters of 31 mm and 22mm, respectively, and a length of 35mm. The venturi was fabricated out of Haynes 25 super alloy which contains grata than 50 wt-% cobalt. All attempts to deposit diamond on this material directly resulted in a film that failed upon cooling. The area needing a diamond protective coating was approximately 1cm in width and extended around the inner diameter of the cone. The screen was attached to the swirler venturi by spot welding. The screen was made out of Mo and was a 10/1 mesh screen with 100 strands/cm in one direction and 10 strands/cm in the other direction. The strands were 0.1cm in diameter, so that in the one direction the strands touched each other and allowed virtually no light to pass through. The strands were woven with perpendicular strands that were 1mm apart. The weave pattern was under 2, over 2, under 2, *etc*.

The reactor system used for the experiment was a typical hot-filament CVD diamond reactor utilizing a 25 mil tungsten filament to activate the gas. The filament temperature was in the 2,000°-2,200°C range and the substrate temperature was in the 850°-950°C range. The reactor was held at 10 torr and the composition of the gas was approximately 1.5% methane in hydrogen. The substrate was rotated to obtain uniformity of the diamond coating.

The substrate was subject to CVD diamond deposition over a one week time period. Thereafter, the swirler venturi was cooled to room temperature. A diamond film greater than 50 microns was found to cover the screen. The diamond layer did not spawl from the venturi upon cooling. In fact, the diamond film was quite tough and resisted scratching with a sharp tool.

## Claims

1. A method for coating a substrate with a layer of chemical vapor deposition (CVD) diamond, which comprises the steps of :
(a) attaching a screen to the area of said substrate to be coated; and
(b) coating said screened area with a layer of CVD diamond.

2. A substrate having a screen attached thereto and a layer of chemical vapor deposition (CVD) diamond adhered to said screen.

3. The method of Claim 1 or substrate of Claim 2 wherein said substrate is one or more of a metal, an alloy, a ceramic, a glass, or carbon.

4. The method or substrate of any preceding claim wherein said substrate is formed from a non-carbide forming material.

5. The method or substrate of any preceding claim wherein said screen is formed from a carbide-forming metal.

6. The method or substrate of any preceding claim wherein said screen is formed from W, Mo, Ta, Si, Pt, or an alloy thereof.

7. The method or substrate of any preceding claim wherein said screen is attached to said substrate by one or more of brazing, welding, or soldering.

8. The method or substrate of any preceding claim wherein said CVD diamond layer ranges in thickness not substantially above about 2,000 micrometers.

9. The method of Claim 8 wherein said layer ranges in thickness from between about 50 and 2,000 micrometers.
